(19) Europäisches Patentamt
European Patent Office
Office européen des brevets

(11) **EP 3 985 607 A1**

(12) **EUROPEAN PATENT APPLICATION**

(43) Date of publication:
**20.04.2022 Bulletin 2022/16**

(21) Application number: **21201997.0**

(22) Date of filing: **11.10.2021**

(51) International Patent Classification (IPC):
**G06T 7/33** (2017.01)     **G01N 21/01** (2006.01)
**G01N 23/2251** (2018.01)

(52) Cooperative Patent Classification (CPC):
**G06T 7/337;** G01N 23/2251; G01N 2223/045;
G01N 2223/401; G01N 2223/417; G01N 2223/418;
G06T 2207/10056; G06T 2207/10061

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **19.10.2020 JP 2020175544**

(71) Applicant: **Jeol Ltd.
Akishima-shi, Tokyo 196-8558 (JP)**

(72) Inventors:
• **OOHORI, Yuichiro
Tokyo, 196-8558 (JP)**
• **MIZUNO, Noriaki
Tokyo, 196-8558 (JP)**
• **SUZUKI, Osamu
Tokyo, 196-8558 (JP)**

(74) Representative: **Boult Wade Tennant LLP
Salisbury Square House
8 Salisbury Square
London EC4Y 8AP (GB)**

(54) **COORDINATE LINKING SYSTEM AND COORDINATE LINKING METHOD**

(57) An observation coordinate in the device coordinate system (16) of an observation device (10) is converted into an observation coordinate in a virtual coordinate system (22), using a conversion formula (24). Subsequently, the observation coordinate in the virtual coordinate system (22) is converted into an observation coordinate in the device coordinate system (18) of another observation device (12), using a reverse conversion formula (32). The virtual coordinate system (22) is a logical coordinate system not depending on any device coordinate system.

FIG. 5

```
        START

MOUNT SAMPLE HOLDER HOLDING
SAMPLE IN OBSERVATION DEVICE A      — S50

      OBSERVE SAMPLE                — S52

SEND OBSERVATION COORDINATE TA IN
DEVICE COORDINATE SYSTEM TO RELAY   — S54
         DEVICE

CONVERT OBSERVATION COORDINATE TA
TO OBSERVATION COORDINATE TS IN     — S56
   VIRTUAL COORDINATE SYSTEM

REVERSELY CONVERT OBSERVATION
COORDINATE TS TO OBSERVATION COORDINATE  — S58
TB IN DEVICE COORDINATE SYSTEM

SEND OBSERVATION COORDINATE TB TO
      OBSERVATION DEVICE B          — S60

MOVE STAGE IN OBSERVATION DEVICE B
ACCORDING TO OBSERVATION            — S62
         COORDINATE TB

      OBSERVE SAMPLE                — S64

   REMOVE SAMPLE HOLDER             — S66

         END
```

EP 3 985 607 A1

**Description**

TECHNICAL FIELD

The present disclosure relates to a coordinate linking system and a coordinate linking method, in particular, a technique for exchanging observation coordinates between a plurality of observation devices.

BACKGROUND

Examples of observation devices for observing samples include optical microscopes, electron microscopes, sample processing devices, and the like. By organizing a plurality of observation devices, it is possible to constitute an observation system. An observation system makes it possible, for example, to observe a sample at a low magnification with an optical microscope and then at a high magnification with an electron microscope. A typical observation system has a system for linking a plurality of coordinate systems of a plurality of observation devices; that is, a system for exchanging observation coordinates between a plurality of coordinate systems. Such a system will be referred to as a coordinate linking system in this specification.

In further detail, a coordinate linking system converts coordinates between a plurality of observation devices that exchange samples. For example, a set of observation coordinates or observation coordinate information (hereinafter may be referred to as "an observation coordinate") in the device coordinate system of a first observation device is converted into an observation coordinate in a device coordinate system of a second observation device. An increasing number of observation systems composed of three or more observation devices are becoming available.

JPH6-258240A describes a coordinate linking system utilizing a common coordinate system. A common coordinate system is a coordinate system defined based on the outer shape or characteristic points of samples, or a coordinate system that is defined by observing samples. The common coordinate system described in this document is a coordinate system that depends on an observation device.

JP2018-55924A describes a coordinate linking system utilizing a sample holder having a plurality of markers thereon. Specifically, one observation device specifies a plurality of pixel coordinates of a plurality of markers, while another observation device specifies a plurality of stage coordinates of the plurality of markers. Based on the plurality of pixel coordinates and the plurality of stage coordinates, a coordinate conversion coefficient sequence is calculated. This document does not disclose a specific coordinate system that does not depend on any observation device.

SUMMARY

In a coordinate linking system, a conversion formula (a conversion coefficient sequence) may be prepared for every pair of observation devices that exchange samples; specifically, for every path for transmission of coordinate information. In this case, however, addition of a new observation device to the coordinate linking system or change to the device coordinate system of an extant observation device included in the coordinate linking system due to maintenance of the observation device will somehow enforce generation or regeneration of a conversion formula. This raises a more significant problem as the number of observation devices constituting the observation system increases.

Hence, it is an object of the present disclosure to implement a coordinate linking system that is readily adapted to addition, change, and so forth of an observation device. Alternatively, it is an object of the present disclosure to implement a new system architecture that links a plurality of device coordinate systems.

A coordinate linking system according to this disclosure includes a conversion means for converting observation coordinate in the first device coordinate system of a first observation device into an observation coordinate in a virtual coordinate system not depending on any observation device; and a reverse conversion means for converting the observation coordinate in the virtual coordinate system into an observation coordinate in the second device coordinate system of a second observation device.

A coordinate linking method according to this disclosure includes a step of converting an observation coordinate in the first device coordinate system of a first observation device into an observation coordinate in a virtual coordinate system not depending on any observation device; and a step of converting the observation coordinate in the virtual coordinate system into an observation coordinate in the second device coordinate system of a second observation device.

BRIEF DESCRIPTION OF DRAWINGS

Embodiment(s) of the present disclosure will be described based on the following figures, wherein:

FIG. 1 is a conceptual diagram illustrating a coordinate linking system according to a first embodiment;

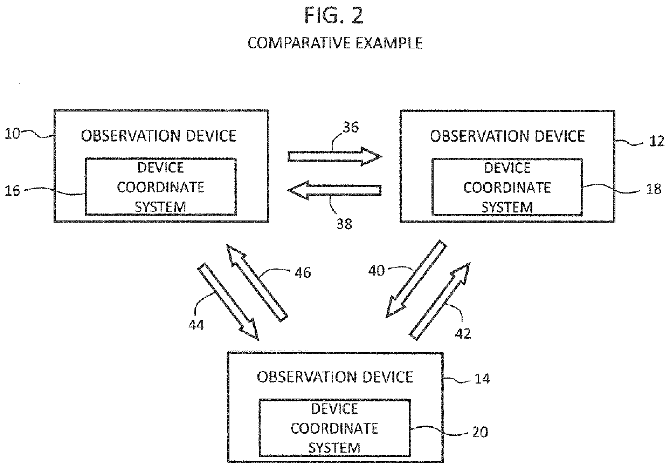

FIG. 2 is a conceptual diagram illustrating a coordinate linking system according to a comparative example;

FIG. 3 is a block diagram relevant to a first embodiment;

FIG. 4 is a flowchart of a preparation process;

FIG. 5 is a flowchart of an operation process;

FIG. 6 is a block diagram relevant to a second embodiment;

FIG. 7 is a block diagram relevant to a third embodiment;

FIG. 8 illustrates parameters that are defined according to a device coordinate system;

FIG. 9 illustrates parameters that are defined according to a virtual coordinate system;

FIG. 10 illustrates a plurality of reference coordinates;

FIG. 11 illustrates reference coordinates for check-up; and

FIG. 12 illustrates a plurality of reference coordinates for height.

DESCRIPTION OF EMBODIMENTS

Embodiments will now be described based on the following drawings.

(1) Outline of Embodiments

A coordinate linking system according to a first embodiment includes a conversion means and a reverse conversion means. The conversion means converts a set of observation coordinates or observation coordinate information (hereinafter may be called "an observation coordinate") in the first device coordinate system of a first observation device into an observation coordinate in a virtual coordinate system not depending on any observation device. The reverse conversion means converts the observation coordinate in the virtual coordinate system into an observation coordinate in the second device coordinate system of a second observation device. The conversion means corresponds to a conversion unit, while the reverse conversion means corresponds to a reverse conversion unit.

In the above-described structure, the first device coordinate system is indirectly linked to the second device coordinate system via the virtual coordinate system. The first device coordinate system is an actual physical coordinate system depending on the first observation device, and the second device coordinate system as well is an actual physical coordinate system depending on the second observation device. Meanwhile, the virtual coordinate system is a logical coordinate system not depending on any observation device. The virtual coordinate system can also be referred to as a reference coordinate system. The virtual coordinate system does not assume any errors or changes over time. That is, the virtual coordinate system itself does not need maintenance. As it is the virtual coordinate system that is directly linked to the respective device coordinate systems, influence of addition, change, or the like of an observation device on the coordinate linking system is only local or limited. This enables ready addition, change, and so forth of an observation device.

The coordinate linking system according to this embodiment includes a conversion formula generating means and a reverse conversion formula generating means. The conversion formula generating means generates a conversion formula for converting an observation coordinate in the first device coordinate system into an observation coordinate in the virtual coordinate system, based on a plurality of actually measured reference coordinates in the first device coordinate system and a plurality of registered reference coordinates in the virtual coordinate system. The reverse conversion formula generating means generates a reverse conversion formula for converting the observation coordinate in the virtual coordinate system into an observation coordinate in the second device coordinate system, based on the plurality of registered reference coordinates in the virtual coordinate system and a plurality of actually measured reference coordinates in the second device coordinate system. The conversion formula generating means corresponds to a conversion formula generating unit. The reverse conversion formula generating means corresponds to a reverse conversion formula generating unit.

At the time of constitution or maintenance of the system, the conversion formula generating means and the reverse conversion formula generating means operate. Once a conversion formula and a reverse conversion formula are generated, the conversion formula and reverse conversion formula can be used thereafter. Alternatively, a conversion formula and a reverse conversion formula may be freshly generated either regularly or upon every conversion of coordinates, when necessary.

In the case of adding any device coordinate system or changing a device coordinate system, it is only necessary to generate or regenerate a conversion formula (or a reverse conversion formula) between the subjected device coordinate system and the virtual coordinate system, and generation or regeneration of a conversion formula (or a reverse conversion formula) between other device coordinate systems and the virtual coordinate system is unnecessary. This gives an advantage that is more significant when a larger number of observation devices are included in the coordinate linking system.

In general, a pair consisting of a conversion formula and a reverse conversion formula is prepared individually between each device coordinate system and the virtual coordinate system. Needless to say, generation of a conversion formula or a reverse conversion formula that is not expected to be used is not necessary. In this embodiment, each of the conversion formula and the reverse conversion formula is substantially a conversion coefficient sequence. Examples of coordinate conversions include coordinate conversions in the horizontal direction, coordinate conversions in the rotational direction, coordinate conversions in the height direction, and so forth. As the virtual coordinate system is substantially cancelled during a series of processes for conversion and reverse conversion, for example, any position on a design drawing can be defined as the origin of the virtual coordinate system.

The coordinate linking system according to this embodiment includes a sample holder having a plurality of markers. The plurality of registered reference coordinates is a plurality of marker coordinates in the virtual coordinate system. The plurality of actually measured reference coordinates in the first device coordinate system is a plurality of marker coordinates that are specified through observation of the plurality of markers by the first observation device with the sample holder mounted on the first observation device. The plurality of actually measured reference coordinates in the second device coordinate system are a plurality of marker coordinates that are specified through observation of the plurality of markers by the second observation device with the sample holder mounted on the second observation device.

The sample holder is normally commonly used by a plurality of observation devices. In this embodiment, the sample holder has a plurality of markers thereon. In this case, a design coordinate system of the sample holder can be used as the virtual coordinate system. A plurality of characteristic points on an actual sample or a dummy sample held by the holder may be used as the plurality of markers. In an operation process, subsequent to a preparation process for generating a conversion formula and a reverse conversion formula, any holder without a plurality of markers can be used.

The coordinate linking system according to this embodiment includes a relay device. The relay device is connected to the first observation device and the second observation device. The relay device includes the conversion means and the reverse conversion means. This structure can provide an advantage in that addition of a specific structure to each observation device is unnecessary in constitution of a coordinate linking system.

In this embodiment, the relay device includes a storage unit for storing an observed image obtained by the first observation device and an observation coordinate in the virtual coordinate system corresponding to the observed image. In this structure, the relay device functions as an image server.

In this embodiment, in giving an observed image read from the storage unit to the second observation device, the relay device converts an observation coordinate in the virtual coordinate system corresponding to the observed image, read from the storage unit, into an observation coordinate in the second device coordinate system, and gives the converted observation coordinate to the second observation device. That is, necessary coordinate conversion is executed when uploading an observed image, and necessary reverse coordinate conversion is executed when downloading an observed image. The plurality of stored observed images may be displayed in a list to have a user select a specific observed image from the list. In this case, the observed image is downloaded to an observation device designated by a user, and simultaneously, the observation coordinate corresponding to the observed image is downloaded. During the process of downloading, the observation coordinate in the virtual coordinate system is converted into an observation coordinate in the device coordinate system to which the downloading is addressed.

In this embodiment, the conversion means includes a first conversion means and a second conversion means. The reverse conversion means includes a first reverse conversion means and a second reverse conversion means. The first conversion means converts a first observation coordinate in the first device coordinate system into a second observation coordinate in the virtual coordinate system. The second conversion means converts a third observation coordinate in the second device coordinate system into a fourth observation coordinate in the virtual coordinate system. The first reverse conversion means converts the fourth observation coordinate in the virtual coordinate system into a fifth observation coordinate in the first device coordinate system. The second reverse conversion means converts the second observation coordinate in the virtual coordinate system into a sixth observation coordinate in the second device coordinate system. The first conversion means corresponds to a first conversion unit. The second conversion means corresponds to a second conversion unit. The first reverse conversion means corresponds to a first reverse conversion unit. The second reverse conversion means corresponds to a second conversion unit.

The coordinate linking system in this embodiment includes a first conversion formula generating means, a second conversion formula generating means, a first reverse conversion formula generating means, and a second reverse conversion generating means. The first conversion formula generating means generates a first conversion formula for converting the first observation coordinate in the first device coordinate system into the second observation coordinate in the virtual coordinate system, based on a plurality of actually measured reference coordinates in the first device coordinate system and a plurality of registered reference coordinates in the virtual coordinate system. The second conversion formula generating means generates a second conversion formula for converting the third observation coordinate in the second device coordinate system into the fourth observation coordinate in the virtual coordinate system, based on a plurality of actually measured reference coordinates in the second device coordinate system and the plurality of registered reference coordinates in the virtual coordinate system. The first reverse conversion formula generating means generates a first reverse conversion formula for converting the fourth observation coordinate in the virtual coordinate system into the fifth observation coordinate in the first device coordinate system, based on the plurality of registered reference coordinates in the virtual coordinate system and the plurality of actually measured reference coordinates in the first device coordinate system. The second reverse conversion formula generating means generates a second reverse conversion formula for converting the second observation coordinate in the virtual coordinate system into the sixth observation coordinate in the second device coordinate system, based on the plurality of registered reference coordinates in the virtual coordinate system and the plurality of actually measured reference coordinates in the second device coordinate system. The first conversion formula generating means corresponds to a first conversion formula generating unit. The second conversion formula generating means corresponds to a second conversion formula generating unit. The first reverse conversion formula generating means corresponds to a first reverse conversion formula generating unit. The second reverse conversion formula generating means corresponds to a second reverse conversion formula generating means.

In this embodiment, the first observation device includes the first conversion means and the first reverse conversion means. The second observation device includes the second conversion means and the second reverse conversion means. With this structure, coordinate conversion necessary in each observation device can be executed.

A coordinate linking method in this embodiment includes a conversion step and a reverse conversion step. In a conversion step, an observation coordinate in the first device coordinate system of a first observation device is converted into an observation coordinate in a virtual coordinate system not depending on any observation device. In a reverse conversion step, the observation coordinate in the virtual coordinate system is converted into an observation coordinate in the second device coordinate system of a second observation device.

The above-described coordinate linking method is implemented using a hardware function or a software function. In the latter case, a program for executing the above-described coordinate linking method is installed in an information processing device via a network or a portable storage medium. The concept of an information processing device encompasses computers, coordinate conversion devices, relay devices, observation devices, observation systems, and so forth. The concept of an observation device can encompass devices for processing or operation with samples. An information processing device can include a non-transitory storage medium storing the above-mentioned program.

(2) Details of Embodiment

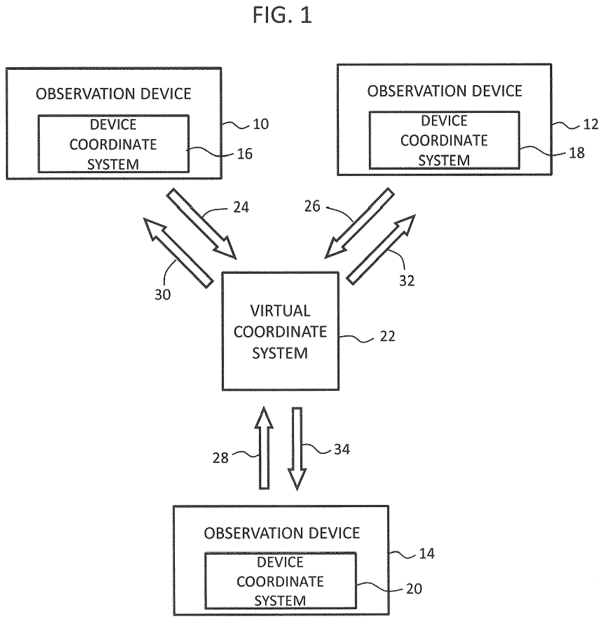

FIG. 1 is a conceptual diagram illustrating a coordinate linking system according to this embodiment. The coordinate linking system is an observation system, and corresponds to a platform part of an observation system. The coordinate linking system is composed of three observation devices 10, 12, 14 in the illustrated embodiment. The respective observation devices 10, 12, 14 are, for example, an optical microscope, an electron microscope, and a sample processing device, respectively. One example of electron microscopes is a scanning electron microscope. One example of a sample processing device is a focused ion beam processing device. A focused ion beam processing device has a function of observing samples, and is one kind of observation device. Various devices having an observation function other than those mentioned above are available.

The observation device 10 has its own unique physical coordinate system, or a device coordinate system 16. The device coordinate system 16 is a coordinate system that is defined relative to a movable stage having a sample holder, for example. Similarly, the observation device 12 and the observation device 14 as well have their own unique physical coordinate systems, or device coordinate systems 18, 20, respectively. The respective device coordinate systems 18, 20 as well are coordinate systems that are defined relative to the respective movable stages having respective sample holders. Needless to say. a beam scanning coordinate system may be used as a device coordinate system.

The plurality of device coordinate systems 16, 18, 20 are indirectly connected to one another via a virtual coordinate system 22. The virtual coordinate system 22 is a design coordinate system of the sample holder in this embodiment. Any coordinate system can be employed as the virtual coordinate system 22. The virtual coordinate system 22 is a logical coordinate system not depending on any of the observation devices 10, 12, 14, and functions as an interface between the plurality of device coordinate systems 16, 18, 20. Even if any change occurs to any of the device coordinate systems 16, 18, 20 due to maintenance or the like, the change does not affect the virtual coordinate system 22. Moreover, addition of a new observation device to the coordinate linking system or deletion of any observation device from the coordinate linking system does not affect the virtual coordinate system 22.

Between the device coordinate system 16 and the virtual coordinate system 22, a conversion formula 24 and a reverse conversion formula 30 are prepared. Using the conversion formula 24, an observation coordinate depending on the device coordinate system 16; that is, an observation coordinate in the device coordinate system 16, is converted into an observation coordinate in the virtual coordinate system 22. Meanwhile, using the reverse conversion formula 30, an observation coordinate in the virtual coordinate system 22 is converted into an observation coordinate in the device coordinate system 16. Note that observation coordinate is the coordinate of a specific portion of a sample, such as, for example, a portion to be observed, a processed portion, or the like. Each of the conversion formula 24 and the reverse conversion formula 30 is substantially a conversion coefficient sequence. Each of a conversion formula and a reverse conversion formula to be described later as well is substantially a conversion coefficient sequence.

Moreover, between the device coordinate system 18 and the virtual coordinate system 22, a conversion formula 26 and a reverse conversion formula 32 are available. Using the conversion formula 26, an observation coordinate in the device coordinate system 18 is converted into an observation coordinate in the virtual coordinate system 22. Meanwhile, using the reverse conversion formula 32, an observation coordinate in the virtual coordinate system 22 is converted into an observation coordinate in the device coordinate system 18.

Furthermore, between the device coordinate system 20 and the virtual coordinate system 22, a conversion formula 28 and a reverse conversion formula 34 are available. Using the conversion formula 28, an observation coordinate in the device coordinate system 20 is converted into an observation coordinate in the virtual coordinate system 22. Meanwhile, using the reverse conversion formula 34, an observation coordinate in the virtual coordinate system 22 is converted into an observation coordinate in the device coordinate system 20.

In the structure illustrated in FIG. 1, for example, in the case that any change occurs to the device coordinate system 20 due to maintenance of the observation device 14, and consequently the conversion formula 28 and the reverse conversion formula 34 are thus required to be regenerated, regeneration of the conversion formulas 24, 26 and the reverse conversion formulas 30, 32 is unnecessary. That is, the extant conversion formulas 24, 26 and reverse conversion formulas 30, 32 remain usable. This is applicable to a case in which any change occurs to the other device coordinate systems 16, 18. In other words, use of a virtual coordinate system not depending on any observation device as an interface can enhance extensiveness and flexibility of a coordinate linking system. This can remarkably reduce a burden in constitution and/or maintenance of a coordinate linking system. comparative example. The coordinate linking system is composed of three observation devices 10, 12, 14, which have device coordinate systems 16, 18,20, respectively. Between the observation device 10 and the observation device 12, conversion formulas 36, 38 are available. Between the observation device 12 and the observation device 14, conversion formulas 40, 42 are available. Between the observation device 10 and the observation device 14, conversion formulas 44, 46 are available. For example, an observation coordinate in the device coordinate system 16 is directly converted into an observation coordinate in the device coordinate system 18, using the conversion formula 36. An observation coordinate in the device coordinate system 18 is directly converted into an observation coordinate in the device coordinate system 16, using the conversion formula 38.

In the comparative example, in which n number of observation devices are included, it is necessary to prepare conversion formulas in the number of nP2. For example, in the case that any change occurs to the device coordinate system 20 due to maintenance of the observation device 14, it is necessary to regenerate four conversion formulas 40, 42, 44, 46.

In contrast, in the embodiment illustrated in FIG. 1, it is necessary to prepare conversion formulas only in the number of 2n. If any change occurs to a specific device coordinate system, regeneration of only two conversion formulas relevant to the changed device coordinate system is necessary. That is, this embodiment can produce an advantage that becomes more significant when a larger number of observation devices are included in a coordinate linking system.

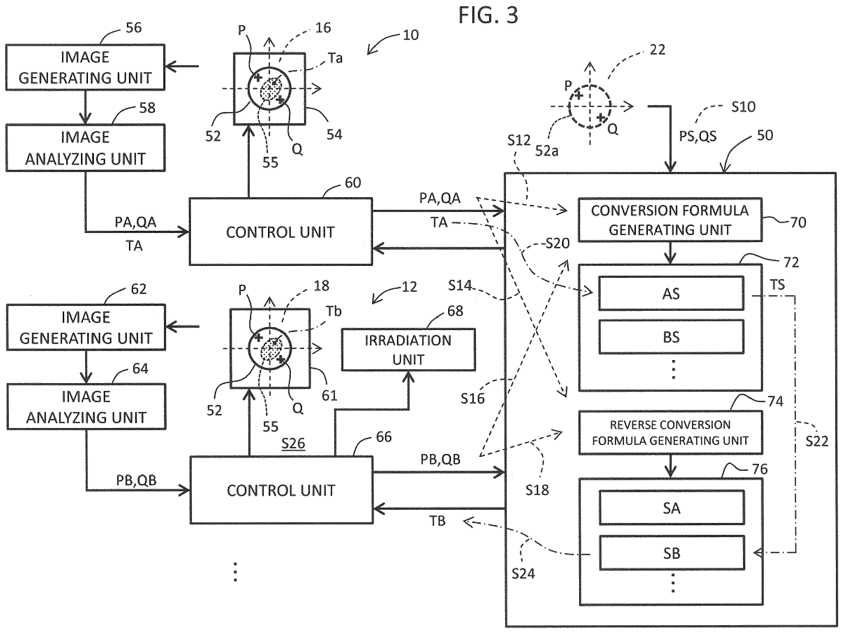

FIG. 3 illustrates a coordinate linking system according to the first embodiment. Specifically, the content illustrated in FIG. 3 corresponds to the concrete embodiment of the content illustrated in FIG. 1.

In FIG. 3, a relay device 50 is provided between the plurality of observation devices 10, 12, and so forth. The relay device 50 is a coordinate linking server including a computer or the like. The plurality of observation devices 10, 12, and so forth are connected to the relay device 50 via a network, not illustrated.

The virtual coordinate system 22 is, for example, a design coordinate system of a sample holder. Reference symbol 52a denotes a design drawing representing a sample holder. The sample holder 52a has two reference points P, Q thereon. In actuality, three or more reference points are desirably provided to assure a certain level of accuracy. Two reference points P, Q are substantially the respective positions of two markers.

The coordinates (reference coordinates) PS of the reference point P and the coordinates (reference coordinates) QS of the reference point Q that are defined according to the virtual coordinate system are given to the relay device 50. The reference coordinate PS and the reference coordinate QS are reference coordinates to be registered in the relay device 50 (registered reference coordinates). For example, the reference coordinates PS and the reference coordinates QS are each composed of an X-axis coordinate and a Y-axis coordinate.

The observation device 10 has a movable stage 54. A coordinate system for controlling the position and the posture of the movable stage 54 is the device coordinate system 16. At a predetermined position on the movable stage 54, a sample holder 52 is mounted in a predetermined orientation. In a preparation process, in which a conversion formula and a reverse conversion formula are generated, the sample holder 52 alone is mounted on the movable stage 54. Meanwhile, in a subsequent sample observation process, or a process in which the coordinate linking system operates, the sample holder 52 holding a sample 55 is mounted on the movable stage 54.

The sample holder 52 has two markers indicative of the respective reference points P, Q. An image of the sample holder 52 is captured with a CCD camera, not illustrated. The CCD camera outputs a signal to an image generating unit 56. The image generating unit 56 generates an image of the upper surface of the sample holder 52. The generated image contains the images of the two markers as parts of the image of the sample holder. In the illustrated exemplary structure, the images of the two markers are extracted through analysis of the image by an image analyzing unit 58, and the coordinates PA, QA of the two reference points are specified from the images of the two markers. The two specified sets of coordinates PA, QA are actually measured reference coordinates.

Alternatively, the image of the sample holder may be shown on a display to have a user designate the positions of two reference points. In this case, the actually measured reference coordinates PA, QA are specified through the designation. In the case that this arrangement is employed, the image analyzing unit 58 is unnecessary. Alternatively, a dummy sample may be provided to the sample holder, and a plurality of characteristic points on the dummy sample may be used as the plurality of reference points. Alternatively, a plurality of characteristic points on an actual sample may be used as a plurality of reference points.

A control unit 60 includes a processor (for example, a central processing unit (CPU)) for executing a program, and functions as a controller and an operating unit. The control unit 60 controls the operation of the observation device 10. The control unit 60 has a function of exchanging data with respect to the relay device 50. The observation device 10 is, for example, an optical microscope. In this case, the position of the movable stage 54 is manually adjusted. In the preparation process, the control unit 60 sends data indicative of the actually measured reference coordinates PA, QA to the relay device 50.

In the operation process, subsequent to the preparation process, the sample holder 52 holding the sample 55 is mounted on the movable stage 54, and the sample 55 is then observed. An image of the sample 55 is captured with a CCD camera. In FIG. 3, Ta indicates a portion of the sample 55 to be observed, or an observed portion, and TA indicates the set of coordinates (hereinafter may be called simply "a coordinate") of the observed portion, or an observation coordinate. The observation coordinate TA is specified based on the position information of the movable stage 54, and specified through analysis of the image of the holder or designation on the image of the holder by a user. In the illustrated example, data indicative of the observation coordinate TA are sent to the relay device 50 in the operation process. Note that a sample holder without two marks or with any other form may be used in the operation process.

Similarly, the observation device 12 has a movable stage 61. A coordinate system for controlling the movable stage 61 is the device coordinate system 18. The observation device 12 is a scanning electron microscope in the illustrated example. Scanning with electronic beams is controlled according to the device coordinate system 18.

In the preparation process, the sample holder 52 is mounted in a predetermined orientation at a predetermined position on the movable stage 61 in the observation device 12 as well. In the subsequent operation process, the sample holder 52 holding the sample 55 is mounted on the movable stage 61. Note that the sample holder 52 may be set in the observation device 12 before the sample holder 52 is set in the observation device 10.

In the observation device 12, an image of the sample holder 52 is captured with a CCD camera, not illustrated. The CCD camera outputs a signal to an image generating unit 62. The image generating unit 62 generates an image of the upper surface of the sample holder 52. The generated image contains the images of the two markers as parts of the image of the sample holder 52. The images of the two markers are extracted through analysis of the image of the sample holder 52 by an image analyzing unit 64, and the coordinates PB, QB of the two reference points are specified from the images of the two markers. The two specified coordinates PB, QB are used as actually measured reference coordinates, respectively. Alternatively, as described earlier, a user may designate the positions of two reference points on the displayed image of the holder.

A control unit 66 includes a processor for executing a program, and functions as a controller and an operating unit. The control unit 66 controls the operation of the observation device 12 including the movable stage 61 and an irradiation unit 68. The control unit 66 has a function of exchanging data with respect to the relay device 50. Specifically, in the preparation process, the control unit 60 sends data indicative of the actually measured reference coordinates PB, QB to the relay device 50.

In the operation process, subsequent to the preparation process, the sample holder 52 holding the sample 55 is mounted on the movable stage 61. Then, an image of the sample 55 is captured with a CCD camera. The irradiation unit 68 is a module for generating and scanning with an electronic beam. An image (an SEM image) of the sample 55 may be generated through scanning with an electronic beam. In FIG. 3, Tb indicates an observed portion of the sample 55, and TB indicates the coordinate of the observed portion, or an observation coordinate. The observation coordinate TB is calculated in the relay device 50, based on the observation coordinate TA, as will described later.

The relay device 50 has a processor for executing a program. In FIG. 3, the plurality of functions implemented by the processor are illustrated as a plurality of blocks. Specifically, the relay device 50 includes a conversion formula generating unit 70, a conversion unit 72, a reverse conversion formula generating unit 74, and a reverse conversion unit 76. Note that, for explicit distinction in direction of coordinate conversion, terms "conversion" and "reverse conversion" will be used with differentiation, although a reverse conversion is one kind of conversion.

The conversion formula generating unit 70 and the reverse conversion formula generating unit 74 function in the preparation process. Specifically, the conversion formula generating unit 70 generates a conversion formula AS for coordinate conversion from the device coordinate system 16 to the virtual coordinate system 22, based on the actually measured reference coordinates PA, QA and the registered reference coordinates PS, QS. Further, the conversion formula generating unit 70 generates a conversion formula BS for coordinate conversion from the device coordinate system 18 to the virtual coordinate system 22, based on the actually measured reference coordinates PB, QB and the registered reference coordinates PS, QS. Each of the conversion formulas AS, BS is substantially a conversion coefficient sequence. The generated conversion formulas AS, BS are given to the conversion unit 72, which functions in the operation process.

Meanwhile, the reverse conversion formula generating unit 74 generates a reverse conversion formula SA for coordinate conversion from the virtual coordinate system 22 to the device coordinate system 16, based on the registered reference coordinates PS, QS and the actually measured reference coordinates PA, QA. Further, the reverse conversion formula generating unit 74 generates a reverse conversion formula SB for coordinate conversion from the virtual coordinate system 22 to the device coordinate system 18, based on the registered reference coordinates PS, QS and the actually measured reference coordinates PB, QB. Each of the reverse conversion formulas SA, SB as well is substantially a conversion coefficient sequence. The generated reverse conversion formulas SA, SB are given to the reverse conversion unit 76, which functions in the operation process.

The above-described conversion formulas and reverse conversion formulas are generated for every observation device 10, 12, and so forth. With the above, the coordinate linking system illustrated in FIG. 1 is constituted.

The operation of the coordinate linking system illustrated in FIG. 3 will now be described. In the preparation process, initially, the registered reference coordinates PS, QS are given to the conversion formula generating unit 70 and the reverse conversion formula generating unit 74 in the relay device 50 (refer to S10). The sample holder 52 is set in the observation device 10, and observed to obtain actually measured reference coordinates PA, QA. The obtained actually measured reference coordinates PA, QA are given to the conversion formula generating unit 70 and the reverse conversion formula generating unit 74 in the relay device 50 (refer to S12 and S14). The conversion formula generating unit 70 generates the conversion formula AS, based on the actually measured reference coordinates PA, QA and the registered reference coordinates PS, QS. Meanwhile, the reverse conversion formula generating unit 74 generates the reverse conversion formula SA, based on the registered reference coordinates PS, QS and the actually measured reference coordinates PA, QA.

Subsequently, the same sample holder 52 is now set in the observation device 12, and observed to obtain actually measured reference coordinates PB, QB. The obtained actually measured reference coordinates PB, QB are given to the conversion formula generating unit 70 and the reverse conversion formula generating unit 74 in the relay device 50 (refer to S16 and S18). The conversion formula generating unit 70 generates the conversion formula BS, based on the actually measured reference coordinates PB, QB and the registered reference coordinates PS, QS. Meanwhile, the reverse conversion formula generating unit 74 generates the reverse conversion formula SB, based on the registered reference coordinates PS, QS and the actually measured reference coordinates PB, QB. The generated conversion formulas AS, BS are registered in the conversion unit 72, while the generated reverse conversion formulas SA, SB are registered in the reverse conversion unit 76. With the above, the preparation process is completed.

In the operation process, in the case that, for example, a sample is observed initially in the observation device 10, and thereafter in the observation device 12, the operation is executed as follows. That is, initially, the observation coordinate TA of an observed portion Ta is specified in the observation device 10, and then given to the conversion unit 72 in the relay device 50 (refer to S20). Using the conversion formula AS, the conversion unit 72 converts the observation coordinate TA into an observation coordinate TS in the virtual coordinate system 22. The observation coordinate TS is given to the reverse conversion unit 76 (refer to S22). Meanwhile, the reverse conversion unit 76 reversely converts the observation coordinate TS into an observation coordinate TB in the device coordinate system 18, using the reverse conversion formula SB. The observation coordinate TB is sent to the control unit 66 in the observation device 12 (refer to S24). The control unit 66 controls the movable stage 61 and scanning with an electronic beam such that the portion Tb specified by the observation coordinate TB is to be observed (refer to S26).

In the operation process, a user need not be aware of the virtual coordinate system. Basically, necessary conversions and reverse conversions are all automatically executed.

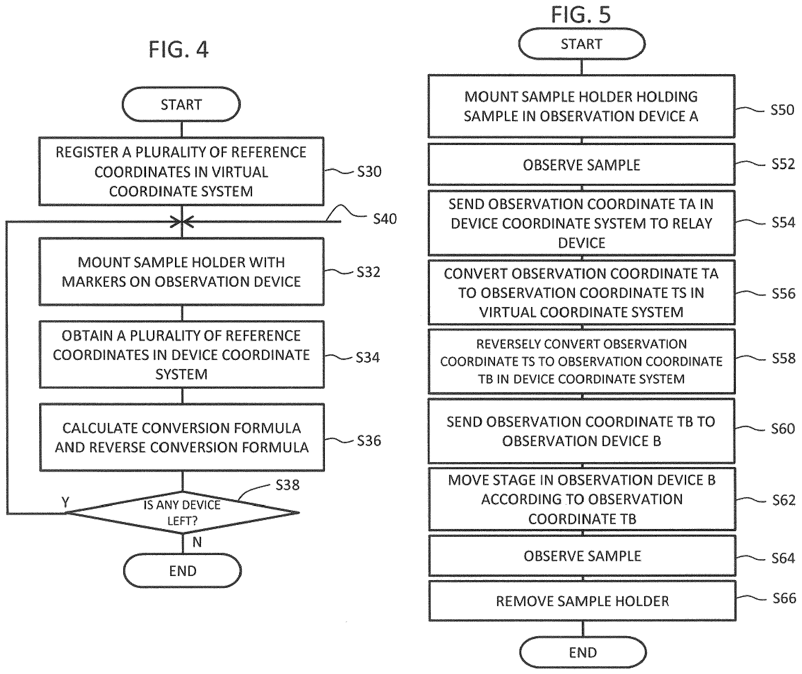

FIG. 4 is a flowchart of the preparation process. FIG. 5 is a flowchart of a typical exemplary operation in the operation process. The preparation process is executed in constitution or maintenance of the system or the like. The operation process is executed for every observation of a sample.

In FIG. 4, in S30, a plurality of reference coordinates in the virtual coordinate system are registered (registered reference coordinates). The registration is conducted by the developer or a person in charge of maintenance of the system (these people are considered to be users in a broad sense). Alternatively, the registration is conducted automatically. In S32, a sample holder with a marker thereon is mounted on the movable stage of an observation device selected from among a plurality of observation devices. In S34, the selected observation device obtains a plurality of actually measured reference coordinates. In S36, the relay device generates a conversion formula and a reverse conversion formula, based on the plurality of registered reference coordinates in the virtual coordinate system and the plurality of actually measured reference coordinates in the device coordinate system. The generated formulas are registered.

In S38, a determination is made as to whether generation of a conversion formula and a reverse conversion formula has been completed with respect to all the observation devices. When the generation is yet to be completed, S32 and subsequent steps are executed again so that conversion formulas and reverse conversion formulas are finally generated for all the observation devices in the coordinate linking system. Needless to say, it is unnecessary to generate a conversion formula or a reverse conversion formula for a path through which transmission of observation coordinates is not expected.

Note that in the case where some or all conversion formulas and reverse conversion formulas are to be regenerated in maintenance of the system, S32 and subsequent steps are executed, as indicated by S40.

In FIG. 5, in S50, a sample holder holding a sample is set in the observation device A. In S52, the sample is observed. After the observation, in S54, the observation coordinate TA in the device coordinate system of the observation device A is sent to the relay device. In S56, the observation coordinate TA is converted into the observation coordinate TS in the virtual coordinate system in the relay device. Subsequently, in S58, the observation coordinate TS is reversely converted into the observation coordinate TB in the device coordinate system. In S60, the observation coordinate TB is sent from the relay device to the observation device B. In S62, movement or the like of the movable stage is controlled, following the observation coordinate TB, in the observation device B. In S64, a portion of the sample specified by the observation coordinate TB is observed. In this case, for example, the position and posture of the movable stage are controlled such that the portion specified by the observation coordinate TB is positioned at the center of the image. Note that the image obtained by the observation device B is a CCD image and an SEM image. With completion of observation of the sample in S66, the sample holder holding the sample is removed from the observation device B.

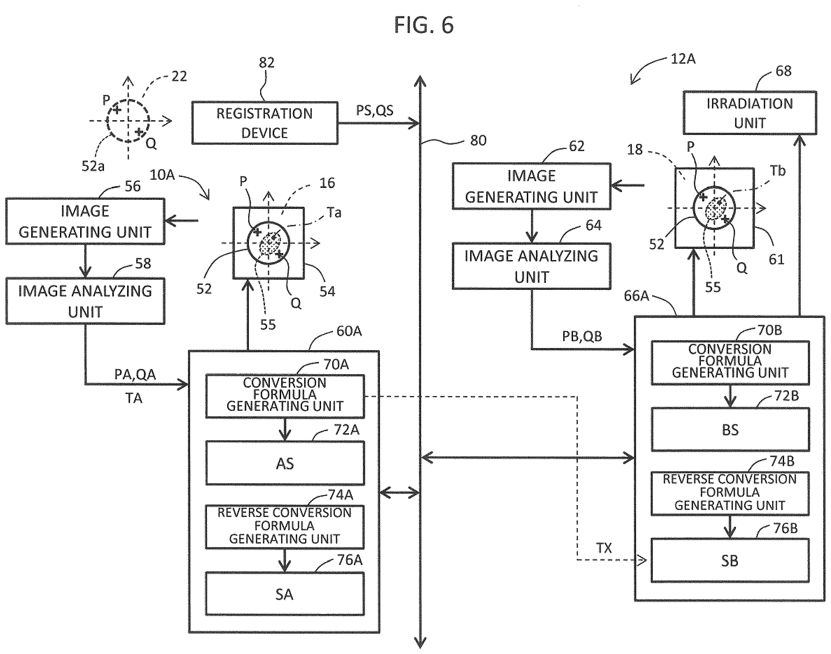

FIG. 6 illustrates a coordinate linking system according to a second embodiment. The content illustrated in FIG. 6 corresponds to the concrete embodiment of the concept illustrated in FIG. 1. Note that components in FIG. 6 identical to those illustrated in FIG. 3 are assigned the same reference symbols, and are not described again.

A network 80 is connected to observation devices 10A, 12A, and so forth, and to a registration device 82 as well. The registration device 82 is a device for providing the registered reference coordinates PS, QS to the observation devices 10A, 12A, and so forth. Alternatively, a user may register the reference coordinates PS, QS (registered reference coordinates PS, QS) in the observation devices 10A, 12A, and so forth.

In the observation device 10A, a control unit 60A includes a conversion formula generating unit 70A, a conversion unit 72A, a reverse conversion formula generating unit 74A, and a reverse conversion unit 76A. The conversion formula generating unit 70A generates the conversion formula AS, based on the actually measured reference coordinates PA, QA and the registered reference coordinates PS, QS. The generated conversion formula AS is given to the conversion unit 72A. Meanwhile, the reverse conversion formula generating unit 74A generates the reverse conversion formula SA, based on the registered reference coordinates PS, QS and the actually measured reference coordinates PA, QA. The generated reverse conversion formula SA is given to the reverse conversion unit 76A.

In the observation device 12A, a control unit 66A includes a conversion formula generating unit 70B, a conversion unit 72B, a reverse conversion formula generating unit 74B, and a reverse conversion unit 76B. The conversion formula generating unit 70B generates the conversion formula BS, based on the actually measured reference coordinates PB, QB and the registered reference coordinates PS, QS. The generated conversion formula SB is given to the conversion unit 72B. Meanwhile, the reverse conversion formula generating unit 74B generates the reverse conversion formula SB, based on the registered reference coordinates PS, QS and the actually measured reference coordinates PB, QB. The generated reverse conversion formula SB is given to the reverse conversion unit 76B. Also in the case where other observation devices are connected to the network 80, each observation device incorporates a conversion formula generating unit, a reverse conversion formula generating unit, a conversion unit, and a reverse conversion unit.

As described above, in the second embodiment, an independent relay device (refer to FIG. 3) is not provided. Instead, the plurality of functions incorporated in the relay device are separately incorporated in the observation devices 10A, 12A, and so forth.

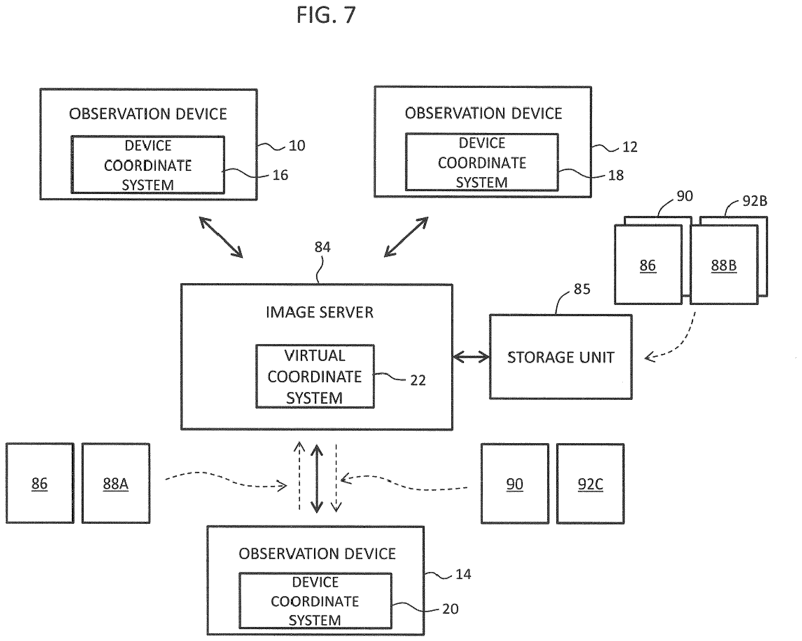

FIG. 7 illustrates a coordinate linking system according to a third embodiment. The plurality of observation devices 10, 12, 14 have device coordinate systems 16, 18, 20, respectively. The plurality of observation devices 10, 12, 14 are mutually connected via an image server 84. The image server 84 functions as a relay device, and has the virtual coordinate system 22. The image server 84 has a storage unit 85.

In uploading an observed image 86 obtained in the observation device 14 to the image server 84, coordinate information 88A is uploaded in addition to the observed image 86. Note that the coordinate information 88A is substantially an observation coordinate used when obtaining the observed image 86, and that the observation coordinate depends on the device coordinate system 20. After being uploaded, the coordinate information 88A is converted into coordinate information 88B in the virtual coordinate system 22, using the coordinate conversion function of the image server 84. In other words, the observation coordinate in the device coordinate system 20 is automatically converted into the observation coordinate in the virtual coordinate system. The coordinate information 88B is stored in the storage unit 85 together with the observed image 86. Processing similar to the above-described processing is executed also in the case that an observed image is uploaded from any of the other observation devices 10, 12 to the image server 84.

In the storage unit 85, an observed image 90 obtained in the observation device 10 and its corresponding coordinate information 92B as well are stored. Note that the coordinate information 92B is coordinate information in the virtual coordinate system 22. When the observation device 14 downloads the observed image 90, the coordinate information 92B is reversely converted into coordinate information 92C in the device coordinate system 20. That is, the observed image and the coordinate information 92C are sent from the image server 84 to the observation device 14. Processing similar to the above-described processing is executed also in the case where an observed image is downloaded to any of the other observation devices 10, 12 from the image server 84.

According to the third embodiment described above, it is possible to automatically generate coordinate information suitable for the transmission destination of an observed image. In the above, an advantage can be obtained in that a user need not be aware that the coordinate systems are different.

In the third embodiment, some or all of the observed images stored in the storage unit 85 may be displayed in a list on a display. For example, a plurality of thumbnail images representative of a plurality of respective observed images may be displayed as tiles. In this case, a user may designate a specific observed image among the plurality of observed images displayed, so that the designated observed image is sent to the designated observation device. According to the third embodiment, coordinate information corresponding to the specific observed image subjected to coordinate conversion is transmitted together with the specific observed image. Alternatively, the coordination information alone may be sent to the specific observation device after designation of an observed image. In displaying a plurality of observed images, a plurality of coordinate information items corresponding to the respective observed images may be displayed. In this case, either a plurality of coordinate information items in the virtual coordinate system or a plurality of coordinate information items in the device coordinate system (the original coordinate information) may be displayed.

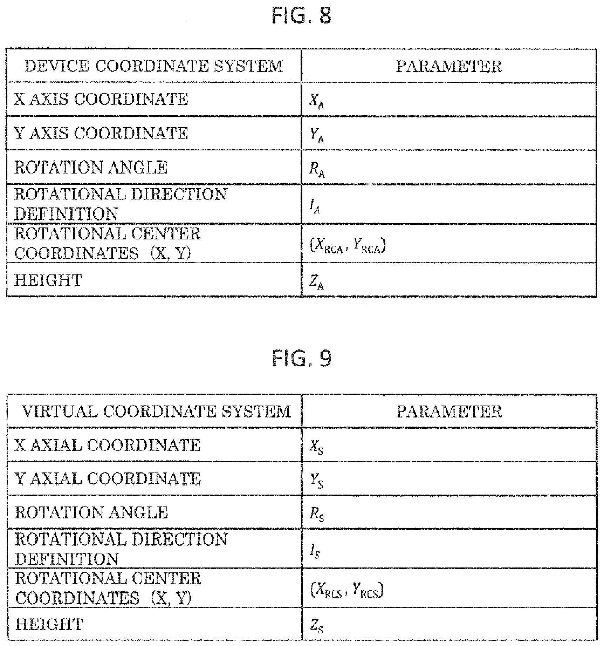

By reference to FIG. 8 to FIG. 10, a specific example of a coordinate conversion will now be described. Specifically, conversion from a device coordinate system of the observation device A to the virtual coordinate system will be described. This is applicable to a reverse conversion as well.

FIG. 8 illustrates parameters according to the device coordinate system of the observation device A. FIG. 9 illustrates parameters according to the virtual coordinate system. In FIG. 8 and FIG. 9, an X-axis coordinate and a Y-axis coordinate indicate the coordinates of a point of interest (a reference point, an observed point) on the X axis and the Y axis, respectively. A rotation angle indicates the rotation angle of the movable stage. A rotational direction definition refers to a definition as to the positive or negative rotational direction of the rotational shaft of the movable stage. Specifically, $I_A$ means +1 in a clockwise rotation, and -1 in a counterclockwise rotation. The coordinates of the center of rotation refer to the coordinates of the center of the rotational shaft of the movable stage. A height refers to the height of the movable stage in the vertical direction.

The content illustrated in FIG. 8 and FIG. 9 is constituted in consideration of versatility. In the virtual coordinate system, the coordinates of the center of rotation may be defined as (0, 0), and the height as 0. Managing the coordinates of the center of the rotational shaft enables accurate calculation of a conversion coefficient sequence even when the center of the rotational shaft does not fall on the origin of the device coordinate system.

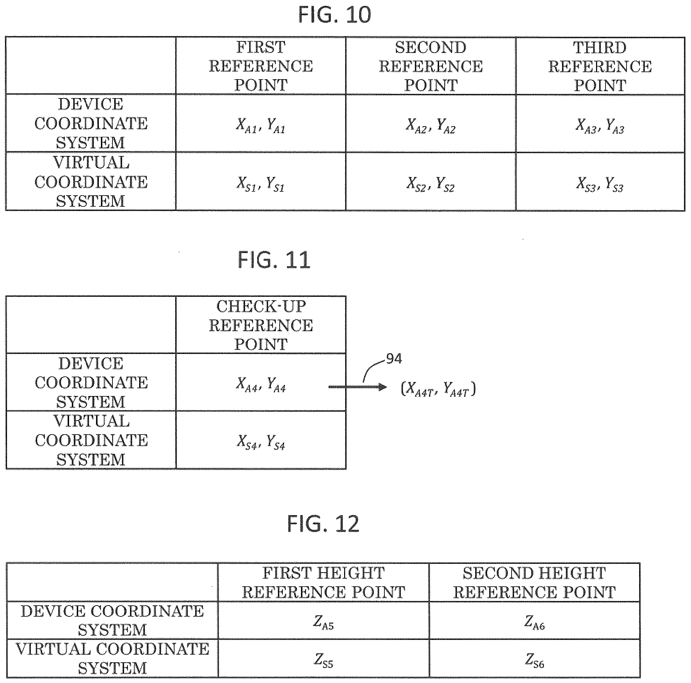

FIG. 10 illustrates coordinates in the device coordinate system (actually measured reference coordinates) and coordinates in the virtual coordinate system (registered reference coordinates) of a first reference point, a second reference point, and a third reference point. The respective reference points correspond to the positions of the markers.

A conversion coefficient sequence ($K_1$, $K_2$, $K_3$, $K_4$, $L_X$, $L_Y$) for coordinate conversion from a coordinate in the device coordinate system of the observation device A into a coordinate in the virtual coordinate system is calculated as follows, for example.

$$K_1 = \frac{(X_{S1} \cdot Y_{A2} - X_{S2} \cdot Y_{A1})(Y_{A3} - Y_{A1}) - (X_{S1} \cdot Y_{A3} - X_{S3} \cdot Y_{A1})(Y_{A2} - Y_{A1})}{(X_{A1} \cdot Y_{A2} - X_{A2} \cdot Y_{A1})(Y_{A3} - Y_{A1}) - (X_{A1} \cdot Y_{A3} - X_{A3} \cdot Y_{A1})(Y_{A2} - Y_{A1})} \quad \cdots (1)$$

$$K_2 = \frac{(X_{S1} \cdot X_{A2} - X_{S2} \cdot X_{A1})(X_{A3} - X_{A1}) - (X_{S1} \cdot X_{A3} - X_{S3} \cdot X_{A1})(X_{A2} - X_{A1})}{(X_{A2} \cdot Y_{A1} - X_{A1} \cdot Y_{A2})(X_{A3} - X_{A1}) - (X_{A3} \cdot Y_{A1} - X_{A1} \cdot Y_{A3})(X_{A2} - X_{A1})} \quad \cdots (2)$$

$$K_3 = \frac{(Y_{S1} \cdot Y_{A2} - Y_{S2} \cdot Y_{A1})(Y_{A3} - Y_{A1}) - (Y_{S1} \cdot Y_{A3} - Y_{S3} \cdot Y_{A1})(Y_{A2} - Y_{A1})}{(X_{A1} \cdot Y_{A2} - X_{A2} \cdot Y_{A1})(Y_{A3} - Y_{A1}) - (X_{A1} \cdot Y_{A3} - X_{A3} \cdot Y_{A1})(Y_{A2} - Y_{A1})} \quad \cdots (3)$$

$$K_4 = \frac{(Y_{S1} \cdot X_{A2} - Y_{S2} \cdot X_{A1})(X_{A3} - X_{A1}) - (Y_{S1} \cdot X_{A3} - Y_{S3} \cdot X_{A1})(X_{A2} - X_{A1})}{(X_{A2} \cdot Y_{A1} - X_{A1} \cdot Y_{A2})(X_{A3} - X_{A1}) - (X_{A3} \cdot Y_{A1} - X_{A1} \cdot Y_{A3})(X_{A2} - X_{A1})} \quad \cdots (4)$$

$$L_X = X_{S1} - K_1 \cdot X_{A1} - K_2 \cdot Y_{A1} \qquad \dots (5)$$

$$L_Y = Y_{S1} - K_3 \cdot X_{A1} - K_4 \cdot Y_{A1} \qquad \dots (6)$$

Coordinate conversion using a conversion coefficient sequence will now be described. Initially, assuming that the stage is rotating in the observation device A, the set of coordinates $(X_A, Y_A)$ obtained while the stage is rotating is converted into a set of coordinates $(X_{R0A}, Y_{R0A})$ with the stage not rotating (the rotation angle 0 degree), as follows.

$$X_{R0A} = (X_A - X_{RCA}) \cos(I_A \cdot R_A \cdot \frac{\pi}{180}) - (Y_A - Y_{RCA}) \sin(I_A \cdot R_A \cdot \frac{\pi}{180}) + X_{RCA} \qquad \dots (7)$$

$$Y_{R0A} = (X_A - X_{RCA}) \sin(I_A \cdot R_A \cdot \frac{\pi}{180}) + (Y_A - Y_{RCA}) \cos(I_A \cdot R_A \cdot \frac{\pi}{180}) + Y_{RCA} \qquad \dots (8)$$

Subsequently, the above-described set of coordinates $(X_{R0A}, Y_{R0A})$ is converted into a set of coordinates $(X_{R0S}, Y_{R0S})$ in the virtual coordinate system, as described below.

$$X_{R0S} = K_1 \cdot X_{R0A} + K_2 \cdot Y_{R0A} + L_X \qquad \dots (9)$$

$$Y_{R0S} = K_3 \cdot X_{R0A} + K_4 \cdot Y_{R0A} + L_Y \qquad \dots (10)$$

Meanwhile, the rotation angle $R_A$ in the observation device A is converted into the rotation angle $R_S$ in the virtual coordinate system.

$$R_S = I_S(I_A \cdot R_A + R_{user}) \qquad \dots (11)$$

Note that the rotation offset value $R_{user}$ in the above is a value which a user can arbitrarily set, and will be described later.
As described above, the set of coordinates $(X_S, Y_S)$ in the virtual coordinate system is calculated as follows in consideration of the rotation of the movable stage.

$$X_S = (X_{R0S} - X_{RCS}) \cos(-I_S \cdot R_S \cdot \frac{\pi}{180}) - (Y_{R0S} - Y_{RCS}) \sin(-I_S \cdot R_S \cdot \frac{\pi}{180}) + X_{RCS} \qquad \dots (12)$$

$$Y_S = (X_{R0S} - X_{RCS}) \sin(-I_S \cdot R_S \cdot \frac{\pi}{180}) + (Y_{R0S} - Y_{RCS}) \cos(-I_S \cdot R_S \cdot \frac{\pi}{180}) + Y_{RCS} \qquad \dots (13)$$

A conversion formula for reverse conversion as well can be similarly obtained, as described above. A conversion formula and a reverse conversion formula for other observation devices can be obtained in the same manner as described above.
As described above, allowing a user to designate a rotation offset value when executing coordinate conversion can improve convenience. For example, in the case where desirable orientation of a sample is determined in advance for every observation device, simply, a corresponding rotation offset value is set.
In the case where, for example, a thin film sample is generated using a focused ion beam processing device, and sent to a pick-up device (a sample operation device) having an optical microscope, the rotation offset value can function effectively. That is, in generation of a thin film sample with a focused ion beam, the angle of rotation of the movable stage is determined, due to restriction on the direction of inclination of the movable stage, such that the orientation of the plane of the thin film sample is parallel to the X axis. Meanwhile, since a probe is to approach a thin film sample from the lateral side of the thin film sample in the pick-up device, the orientation of the thin film sample is desirably determined such that the orientation of the plane of the thin film sample is parallel to the Y direction of the stage.

In the above-described case, the rotation offset value is set to 90 degrees in coordinate conversion from the virtual coordinate system to the device coordinate system of the pick-up device. With this setting, the movable stage automatically rotates by 90 degrees for every transportation of a thin film sample, and manual designation of the rotation angle by a user is unnecessary. A graphic user interface (GUI) having a space for inputting a rotation offset value may be displayed on the screen of a display.

In order to check whether the generated conversion formula (or a reverse conversion formula) works properly, an automatic checkup may be executed. In this case, as illustrated in FIG. 11, a reference checkup point is determined. Specifically, a coordinate in the device coordinate system is given to a conversion formula (refer to reference symbol 94) to compare the coordinate obtained through conversion with the registered reference coordinate in the virtual coordinate system. For the comparison, a margin for tolerance of a certain extent of error may be determined.

In coordinate conversion, additionally, the height of a sample may be converted. In this case, as illustrated in FIG. 12, a first height reference point and a second height reference point are determined, so that a conversion coefficient sequence for height can be calculated as described below, using these points.

$$K_5 = \frac{Z_{S5} - Z_{S6}}{Z_{A5} - Z_{A6}} \qquad \dots (14)$$

$$L_Z = Z_{S5} - K_5 \cdot Z_{A5} \qquad \dots (15)$$

With the above, coordinate conversion for height can be executed as follows.

$$Z_S = K_5 \cdot Z_A + L_Z \qquad \dots (16)$$

Conversion of the height of a sample is very useful in transportation of a sample from an optical microscope to an electron microscope. That is, since the focal depth of an electron microscope is deep, it is difficult to obtain accurate height of a sample, based on the focus information. Meanwhile, since the focal depth of an optical microscope is shallow, it is possible to obtain the accurate height of a sample from the focus information. Reproduction of the height of a sample, obtained with an optical microscope, on an electron microscope enables accurate adjustment in height of a sample, which is difficult to achieve using an electron microscope alone.

According to the above-described embodiments, a coordinate linking system readily adapted to addition, change, and so forth of an observation device can be implemented. In other words, a new architecture for linking a plurality of device coordinate systems can be achieved. The coordinate linking method according to the above-described embodiments and any other more accurate coordinate linking method may be used in combination. For example, when position determination with a standard level of accuracy is required, the coordinate linking method according to the embodiments here may be selected, while when position determination with higher accuracy is required, other coordinate linking methods may be selected. Alternatively, a modified example in which a coordinate linking method other than the coordinate linking method according to the embodiments is used in addition to the coordinate linking method according to the embodiments is applicable. Note that in the above-described embodiments, any coordinates (for example, characteristic points of a sample, representative points of a movable stage) other than the observation coordinates may be converted.

**Claims**

**1.** A coordinate linking system, comprising:

conversion means (72, 72A, 72B) for converting an observation coordinate in a first device coordinate system (16) of a first observation device (10) into an observation coordinate in a virtual coordinate system (22) not depending on any observation device; and
reverse conversion means (76, 76A, 76B) for converting the observation coordinate in the virtual coordinate system (22) into an observation coordinate in a second device coordinate system (18) of a second observation device (12).

**2.** The coordinate linking system according to claim 1, further comprising:

conversion formula generating means (70, 70A, 70B) for generating a conversion formula for converting the observation coordinate in the first device coordinate system (16) into the observation coordinate in the virtual coordinate system (22), based on a plurality of actually measured reference coordinates in the first device coordinate system (16) and a plurality of registered reference coordinates in the virtual coordinate system (22); and

reverse conversion formula generating means (74, 74A, 74B) for generating a reverse conversion formula for converting the observation coordinate in the virtual coordinate system (22) into the observation coordinate in the second device coordinate system (18), based on the plurality of registered reference coordinates in the virtual coordinate system (22) and a plurality of actually measured reference coordinates in the second device coordinate system (18).

3. The coordinate linking system according to claim 2, further comprising a sample holder (52) having a plurality of markers,
wherein

the plurality of registered reference coordinates in the virtual coordinate system (22) are a plurality of marker coordinates in the virtual coordinate system (22),
the plurality of actually measured reference coordinates in the first device coordinate system (16) are a plurality of marker coordinates that are specified through observation of the plurality of markers by the first observation device (10) with the sample holder (52) mounted on the first observation device (10), and
the plurality of actually measured reference coordinates in the second device coordinate system (18) are a plurality of marker coordinates that are specified through observation of the plurality of markers by the second observation device (12) with the sample holder (52) mounted on the second observation device (12).

4. The coordinate linking system according to claim 1, further comprising:
a relay device (50, 84) including the conversion means (72) and the reverse conversion means (76), the relay device (50, 84) being connected to the first observation device (10) and the second observation device (12).

5. The coordinate linking system claim 4, wherein the relay device (84) includes a storage unit (85) for storing an observed image obtained by the first observation device (10) and an observation coordinate in the virtual coordinate system corresponding to the observed image.

6. The coordinate linking system according to claim 5, wherein, in giving the observed image read from the storage unit to the second observation device (12), the relay device (84) converts the observation coordinate in the virtual coordinate system corresponding to the observed image (22), read from the storage unit (85), into an observation coordinate in the second device coordinate system (18), and gives the observation coordinate converted to the second observation device (12).

7. The coordinate linking system according to claim 1, wherein

the observation coordinate in the first device coordinate system (16) is a first observation coordinate,
the observation coordinate in the virtual system (22) is a second observation coordinate,
the observation coordinate in the second device coordinate system (18) is a sixth observation coordinate,
the conversion means includes

first conversion means (72, 72a) for converting the first observation coordinate in the first device coordinate system (16) into the second observation coordinate in the virtual coordinate system (22), and
second conversion means (72, 72b) for converting a third observation coordinate in the second device coordinate system (18) into a fourth observation coordinate in the virtual coordinate system (22), and

the reverse conversion means includes

first reverse conversion means (76, 76a) for converting the fourth observation coordinate in the virtual coordinate system (22) into a fifth observation coordinate in the first device coordinate system (16), and
second reverse conversion means (76, 76B) for converting the second observation coordinate in the virtual coordinate system (22) into the sixth observation coordinate in the second device coordinate system (18).

8. The coordinate linking system according to claim 7, further comprising:

first conversion formula generating means (70, 70A) for generating a first conversion formula for converting the first observation coordinate in the first device coordinate system (16) into the second observation coordinate in the virtual coordinate system (22), based on a plurality of actually measured reference coordinates in the first device coordinate system (16) and a plurality of registered reference coordinates in the virtual coordinate system, second conversion formula generating means (70, 70B) for generating a second conversion formula for converting the third observation coordinate in the second device coordinate system (18) into the fourth observation coordinate in the virtual coordinate system (22), based on a plurality of actually measured reference coordinates in the second device coordinate system (18) and the plurality of registered reference coordinates in the virtual coordinate system (22),

first reverse conversion formula generating means (74, 74A) for generating a first reverse conversion formula for converting the fourth observation coordinate in the virtual coordinate system (22) into the fifth observation coordinate in the first device coordinate system (16), based on the plurality of registered reference coordinates in the virtual coordinate system (22) and the plurality of actually measured reference coordinates in the first device coordinate system (16), and

second reverse conversion formula generating means (74, 74B) for generating a second reverse conversion formula for converting the second observation coordinate in the virtual coordinate system (22) into the sixth observation coordinate in the second device coordinate system (18), based on the plurality of registered reference coordinates in the virtual coordinate system (22) and the plurality of actually measured reference coordinates in the second device coordinate system (18).

9. The coordinate linking system according to claim 7, wherein

the first observation device (10) includes the first conversion means (72A) and the first reverse conversion means (76A), and
the second observation device (12) includes the second conversion means (72A) and the second reverse conversion means (76B).

10. A coordinate linking method, comprising:

a step of converting an observation coordinate in a first device coordinate system (16) of a first observation device (10) into an observation coordinate in a virtual coordinate system (22) not depending on any observation device; and
a step of converting the observation coordinate in the virtual coordinate system (22) into an observation coordinate in a second device coordinate system (18) of a second observation device (12).

11. A program to be executed in an information processing device, comprising:

a function of converting an observation coordinate in a first device coordinate system (16) of a first observation device (10) into an observation coordinate in a virtual coordinate system (22) not depending on any observation device; and
a function of converting the observation coordinate in the virtual coordinate system (22) into an observation coordinate in a second device coordinate system (18) of a second observation device (12).

FIG. 1

FIG. 2

COMPARATIVE EXAMPLE

FIG. 3

## FIG. 4

START

REGISTER A PLURALITY OF REFERENCE COORDINATES IN VIRTUAL COORDINATE SYSTEM — S30

— S40

MOUNT SAMPLE HOLDER WITH MARKERS ON OBSERVATION DEVICE — S32

OBTAIN A PLURALITY OF REFERENCE COORDINATES IN DEVICE COORDINATE SYSTEM — S34

CALCULATE CONVERSION FORMULA AND REVERSE CONVERSION FORMULA — S36

S38

Y — IS ANY DEVICE LEFT?

N

END

## FIG. 5

START

MOUNT SAMPLE HOLDER HOLDING SAMPLE IN OBSERVATION DEVICE A — S50

OBSERVE SAMPLE — S52

SEND OBSERVATION COORDINATE TA IN DEVICE COORDINATE SYSTEM TO RELAY DEVICE — S54

CONVERT OBSERVATION COORDINATE TA TO OBSERVATION COORDINATE TS IN VIRTUAL COORDINATE SYSTEM — S56

REVERSELY CONVERT OBSERVATION COORDINATE TS TO OBSERVATION COORDINATE TB IN DEVICE COORDINATE SYSTEM — S58

SEND OBSERVATION COORDINATE TB TO OBSERVATION DEVICE B — S60

MOVE STAGE IN OBSERVATION DEVICE B ACCORDING TO OBSERVATION COORDINATE TB — S62

OBSERVE SAMPLE — S64

REMOVE SAMPLE HOLDER — S66

END

# FIG. 6

EP 3 985 607 A1

FIG. 7

EP 3 985 607 A1

## FIG. 8

| DEVICE COORDINATE SYSTEM | PARAMETER |
|---|---|
| X AXIS COORDINATE | $X_A$ |
| Y AXIS COORDINATE | $Y_A$ |
| ROTATION ANGLE | $R_A$ |
| ROTATIONAL DIRECTION DEFINITION | $I_A$ |
| ROTATIONAL CENTER COORDINATES (X, Y) | $(X_{RCA}, Y_{RCA})$ |
| HEIGHT | $Z_A$ |

## FIG. 9

| VIRTUAL COORDINATE SYSTEM | PARAMETER |
|---|---|
| X AXIAL COORDINATE | $X_S$ |
| Y AXIAL COORDINATE | $Y_S$ |
| ROTATION ANGLE | $R_S$ |
| ROTATIONAL DIRECTION DEFINITION | $I_S$ |
| ROTATIONAL CENTER COORDINATES (X, Y) | $(X_{RCS}, Y_{RCS})$ |
| HEIGHT | $Z_S$ |

## FIG. 10

|  | FIRST REFERENCE POINT | SECOND REFERENCE POINT | THIRD REFERENCE POINT |
|---|---|---|---|
| DEVICE COORDINATE SYSTEM | $X_{A1}, Y_{A1}$ | $X_{A2}, Y_{A2}$ | $X_{A3}, Y_{A3}$ |
| VIRTUAL COORDINATE SYSTEM | $X_{S1}, Y_{S1}$ | $X_{S2}, Y_{S2}$ | $X_{S3}, Y_{S3}$ |

## FIG. 11

|  | CHECK-UP REFERENCE POINT |
|---|---|
| DEVICE COORDINATE SYSTEM | $X_{A4}, Y_{A4}$ |
| VIRTUAL COORDINATE SYSTEM | $X_{S4}, Y_{S4}$ |

94

$(X_{A4T}, Y_{A4T})$

## FIG. 12

|  | FIRST HEIGHT REFERENCE POINT | SECOND HEIGHT REFERENCE POINT |
|---|---|---|
| DEVICE COORDINATE SYSTEM | $Z_{A5}$ | $Z_{A6}$ |
| VIRTUAL COORDINATE SYSTEM | $Z_{S5}$ | $Z_{S6}$ |

Europäisches Patentamt

European Patent Office

Office européen des brevets

**EUROPEAN SEARCH REPORT**

Application Number

EP 21 20 1997

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/131241 A1 (CURRY DOUGLAS N [US] ET AL) 8 July 2004 (2004-07-08)<br>* paragraph [0015] *<br>* paragraph [0063] – paragraph [0069] *<br>* claim 4 *<br>* figures 5, 6 * | 1–11 | INV.<br>G06T7/33<br><br>ADD.<br>G01N21/01<br>G01N23/2251 |
| X | US 2012/328178 A1 (REMISZEWSKI STANLEY [US] ET AL) 27 December 2012 (2012-12-27)<br>* paragraph [0156] – paragraph [0203] *<br>* figures 3, 4A, 4B, 4C * | 1–11 | |
| X | US 2011/040169 A1 (KAMEN ALI [US] ET AL) 17 February 2011 (2011-02-17)<br>* paragraph [0016] – paragraph [0099] *<br>* figures 2, 4 * | 1–11 | |
| X | US 2005/236569 A1 (YAMAGUCHI KOHEI [JP] ET AL) 27 October 2005 (2005-10-27)<br>* paragraph [0027] – paragraph [0053] *<br>* figures 1–4 * | 1–11 | |
| X | EP 0 727 660 A2 (SEIKO INSTR INC [JP]; MITSUBISHI ELECTRIC CORP [JP]) 21 August 1996 (1996-08-21)<br>* column 15, line 55 – column 21, line 35 * | 1–11 | TECHNICAL FIELDS SEARCHED (IPC)<br><br>G06T<br>G01N |

The present search report has been drawn up for all claims

| Place of search | Date of completion of the search | Examiner |
|---|---|---|
| Munich | 24 February 2022 | Gitzenis, Savvas |

EPO FORM 1503 03.82 (P04C01)

## ANNEX TO THE EUROPEAN SEARCH REPORT
## ON EUROPEAN PATENT APPLICATION NO.

EP 21 20 1997

This annex lists the patent family members relating to the patent documents cited in the above-mentioned European search report.
The members are as contained in the European Patent Office EDP file on
The European Patent Office is in no way liable for these particulars which are merely given for the purpose of information.

24-02-2022

| Patent document cited in search report | | Publication date | Patent family member(s) | | Publication date |
|---|---|---|---|---|---|
| US 2004131241 | A1 | 08-07-2004 | EP | 1544796 A2 | 22-06-2005 |
| | | | JP | 5563614 B2 | 30-07-2014 |
| | | | JP | 2005181312 A | 07-07-2005 |
| | | | JP | 2012177697 A | 13-09-2012 |
| | | | US | 2004131241 A1 | 08-07-2004 |
| US 2012328178 | A1 | 27-12-2012 | US | 2012328178 A1 | 27-12-2012 |
| | | | US | 2016012591 A1 | 14-01-2016 |
| | | | US | 2017061599 A1 | 02-03-2017 |
| | | | US | 2018108163 A1 | 19-04-2018 |
| US 2011040169 | A1 | 17-02-2011 | NONE | | |
| US 2005236569 | A1 | 27-10-2005 | JP | 4163654 B2 | 08-10-2008 |
| | | | JP | 2005310428 A | 04-11-2005 |
| | | | US | 2005236569 A1 | 27-10-2005 |
| EP 0727660 | A2 | 21-08-1996 | EP | 0727660 A2 | 21-08-1996 |
| | | | JP | 3130222 B2 | 31-01-2001 |
| | | | JP | H08220006 A | 30-08-1996 |
| | | | US | 5877035 A | 02-03-1999 |
| | | | US | 6255127 B1 | 03-07-2001 |

EPO FORM P0459

For more details about this annex : see Official Journal of the European Patent Office, No. 12/82

**EP 3 985 607 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018055924 A